(19) Europäisches Patentamt
European Patent Office
Office européen des brevets

(11) EP 0 260 899 B1

(12) EUROPEAN PATENT SPECIFICATION

(45) Date of publication and mention of the grant of the patent: **10.04.1996 Bulletin 1996/15**

(51) Int Cl.$^6$: **G03F 7/095**

(21) Application number: **87308073.3**

(22) Date of filing: **11.09.1987**

(54) **Photosensitive resin composition and method for producing fine patterns using the photosensitive resin**

Photoempfindliche Kunststoffzusammensetzung und Verfahren zur Herstellung von Feinstrukturen mit dieser Zusammensetzung

Composition résineuse photosensible et procédé pour obtenir des structures très fines avec cette composition

(84) Designated Contracting States:
**BE DE FR GB NL**

(30) Priority: **12.09.1986 JP 213739/86**

(43) Date of publication of application:
**23.03.1988 Bulletin 1988/12**

(73) Proprietor: **MATSUSHITA ELECTRIC INDUSTRIAL CO., LTD.**
**Kadoma-shi Osaka (JP)**

(72) Inventors:
- **Hasegawa, Masazumi**
  **Shinnanyo-shi Yamaguchi (JP)**
- **Endo, Masayuki**
  **1006 Oaza Kadoma Kadoma-shi Osaka (JP)**
- **Ogawa, Kazufumi**
  **1006 Oaza Kadoma Kadoma-shi Osaka (JP)**
- **Todoko, Masaaki**
  **Shinnanyo-shi Yamaguchi (JP)**
- **Fukuda, Mitsutoshi**
  **Tokuyama-shi Yamaguchi (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 110 165**
**EP-A- 0 161 660**
**GB-A- 818 911**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 260 899 B1

Printed by Jouve, 75001 PARIS (FR)

## Description

FIELD OF THE INVENTION

This invention relates to a photosensitive resin composition for producing fine patterns in the field of semiconductor and a method for producing fine patterns using the photosensitive resin. More particularly, this invention relates to a photosensitive resin composition which is adapted for improving both dimensional precision and resolution of patterns by applying a resist as a lower layer and then a solution of a photosensitive resin as an upper layer on a substrate and again increasing the contrast of an exposed light after passing through a mask upon exposure to light.

BACKGROUND OF THE INVENTION

With the increase of integration scale of integrated circuit, the feature sizes of patterns tend to shrink more and more and, recently, a high precise pattern profile of less than about 1 μm in line width has been demanded. For meeting this demand, various methods have been proposed.

For example, from the aspect of apparatus, following two points:

(1) use of a light source of shorter wavelengths; and

(2) use of lens having a large numerical aperture have been proposed for increasing the resolution from optical theory, and machines of plot type are marketed. However, when a light source having shorter wavelengths is used, the transmittance of lens is reduced and, thus, a sufficient amount of the light is not obtained. Also, when a lens having a large numerical aperture is used, there occurs a problem that the resolution becomes worse on the wafer with topography because the depth of focus becomes shallow.

On the other hand, from the aspect of resist, the development of a resist having high contrast (hereinafter referred to as "high resist") has been attempted. A high resist surely improves the resolution to a some extent. Also, the high resist can be produced by controlling the molecular weight and dispersion degree of a polymer in the resist. However, in the case of using such a high resist, there is a restriction on the material to be used, and the resolution is not improved to a great extent.

Also, from the aspect of lithography, there are proposed the following methods:

(1) a method of using a multilayer resist; and

(2) a method of spin-coating a photosensitive resin on a resist film.

The method of using a multilayer resist can certainly provide patterns having a high resolution of less than 1 μm, but is still incomplete as an industrial technique because the process is complicated, the production of device requires a too long period of time, and the productivity is low.

In the method of spin-coating a photosensitive resin on a resist film, the resolution is improved as follows. That is, a light after passing through a mask has high contrast, but the contrast of the light is reduced after the light passes through a space and lens. In this regard, according to the improved method, the reduced contrast of the light is increased again by passing through the photosensitive resin to thereby improve the resolution.

As a photobleachable material contained in the photosensitive resin, there are proposed nitron compounds as described, for example, in Japanese Patent Application (OPI) No. 104642/84 or diazonium salts as described, for example, in Japanese Patent Application (OPI) No. 238829/85 (the term "OPI" as used herein refers to an "unexamined published patent application").

The method of using a nitron compound may certainly improve the resolution, but since in the method an interlayer is required between a resist layer as a lower layer and a photosensitive layer as an upper layer, there are problems that the process becomes complicated and that the productivity is not so improved.

In the method of using a diazonium salt, the improvement effect for resolution is not yet satisfactory, and the diazonium salt to be used has problems in terms of storage stability.

The inventors have investigated on the method of using a diazonium salt as a photobleachable agent in the aforesaid methods of forming a photosensitive layer which is bleached by light, based on the considerations that a method capable of simultaneously developing a photo-sensitive layer with the developer of the lower layer can simplify the process and that a great improvement of resolution can be expected in this case.

As the result of investigations using a method reported as an evaluation method for the mechanism of positive photoresist (F.H. Drill et al, Characterization of Positive Photoresist, IEEE Transactions on Electron Devices, Vol. ED-22, No. 7, July 1975 by IBM Corp., U.S.A.), the inventors have discovered that the resolution can be greatly improved by increasing an A value as defined below.

The A value is generally shown by the following equation:

$$A=\frac{1}{d}\,ln\frac{T(\infty)}{T(0)}$$

T(0): Initial Transmittance
T(∞): Final Transmittance
d: Film Thickness

For increasing the A value, it can be considered to reduce the film thickness (d), give a high transmittance to the photosensitive layer (upper layer) after bleaching (that is, the value of T(∞) is near l00% as close as possible), and also reduce the initial transmittance T(0) as low as possible. In order to reduce the value of T(0), the concentration of a diazonium salt as a photobleachable agent in the photosensitive layer may be increased, but if the concentration thereof is increased, crystals of the photobleachable agent deposit after coating, which results in rather reducing the resolution.

Also, a method of adding an additive for increasing the solubility cannot increase the effect owing to the limitation on the addition amount thereof because the coating properties of the photosensitive layer are reduced.

Furthermore, there is also a problem that the diazonium salt is poor in heat stability.

For solving the above described problems, the present inventors have made various investigations while paying a special attention to a counter anion of the diazonium salt, and as the result, it has been discovered that by using a compound having an organic acid group whose pKa is not more than 2 or a sulfonic group as a counter anion of the diazonium salt, a large amount of the diazonium salt can be dissolved in water without impairing the coating properties and, at the same time, the stability of the diazonium salt can also be improved. As the result thereof, fine patterns can be produced with high precision, and based on these discoveries, the present invention has been attained.

EP-A-0161660 discloses a pattern forming method which comprises the steps of:

providing a resist film on a substrate;
providing a photosensitive film containing a photosensitive diazonium salt on the resist film; and then
subjecting the resultant composite to pattern exposure by use of a light to which both of a resist film and the photosensitive diazonium salt are sensitive. A composition for use in the above method is disclosed which comprises a photosensitive diazonium salt, a resin binder and a solvent. In example 1 there is disclosed a photosensitive solution which comprises 2,5-diethoxy-4-morpholinobenzene-diazonium chloride ½ zinc chloride double salt, polyvinyl pyrrolidone and water. In example 26 there is disclosed a photosensitive solution comprising 3-methoxy-4-pyrrolidylbenzenediazoniumsulfosalicylic acid salt, cellulose acetate and trichloroethane. However, there is no disclosure in this document of a photosensitive resin composition having in combination a diazonium salt containing as counter anion a disulfonic acid anion and a binder with a low pKa.

## SUMMARY OF THE INVENTION

In one aspect the invention provides a photosensitive resin composition as set out in claim 1. Embodiments of the above composition can be used to produce fine patterns with high precision by a simple process.

In another aspect the invention provides a method for producing fine patterns as set out in claim 4.

## DETAILED DESCRIPTION OF THE INVENTION

The counter anions usable in this invention include any compounds containing an organic acid group or a sulfonic group having a low pKa, which are represented by formulae (I) and/or (II) of claim 1.

There is no particular restriction with respect to the molar ratio of the sulfonic acid group in the above-described compound as the counter anion to the diazo group in the diazonium salt, but it is preferred that the molar ratio of the sulfonic group to the diazo group is l.l/l or more.

In this invention, any polymers which are, when dissolved in water, dissociated to become an ion and show a pKa value of 2 or less may be used as a polymer for the photosensitive resin, but polymers having a sulfonic group are preferably used. For example, there are polyvinyl-sulfonic acid, chondroitin sulfuric acid, and salts of these acids as such a polymer, but a polymer having a structural unit shown by formula (III) is most preferably used.

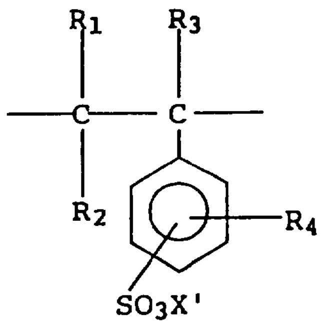

(III)

wherein $R_1$, $R_2$, and $R_3$ each represents a hydrogen atom, an alkyl group having from I to 4 carbon atoms, a halogen atom, or a nitrile group; $R_4$ represents a hydrogen atom, an alkyl group having from 1 to 4 carbon atoms, a halogen atom, a hydroxyl group, or a carboxyl group; and X′ represents a hydrogen atom, an alkali metal, an alkaline earth metal, or an ammonium group.

The polymer for use in this invention may be a copolymer of compounds themselves each shown by the structural unit of formula (III) described above or a copolymer of the compound shown by the aforesaid structural unit of formula (III) and other generally known copolymerizable compound (i.e., a comonomer).

Examples of such a comonomer are styrene, α-methylstyrene, vinylpyridine, acenaphthylene, vinylaniline, vinylnaphthalene, vinylacetophenone, acrylic acid or derivatives thereof, methacrylic acid or esters thereof, acrylonitrile, maleic anhydride, maleimide or derivatives thereof, allyl esters, vinyl esters, acrolein, acrylamide or modified products thereof, propenylanisole, vinyl ethers, indene, isoprene, etc.

There is no particular restriction on the copolymerization ratio of the sulfonic group-containing structural unit compound to the aforesaid comonomer, but it is preferred that the polymer contains at least 50 mol% of the sulfonic group-containing structural unit compound.

Further, if necessary, additives such as phosphoric acid, benzenesulfuric acid or salts thereof, sulfosalicylic acid or salts thereof, nicotinic acid, caffeine, etc. may also be added to the photosensitive resin solution.

Then, a method for producing patterns of this invention is explained in detail.

First, a resist, preferably a positive photoresist, which is ordinarily used as a photoresist, is spin-coated on a wafer. Any positive resists which can be dissolved together with the photosensitive resin by a developer for the resist can be used as the positive photoresist in this invention.

After spin-coating the resist, prebaking is conducted and, thereafter, a photosensitive resin composed of a diazonium salt, water and/or an organic solvent, and a polymer as prepared above is spin-coated on the resist layer. Conventionally known diazonium salts which absorb well the light from a light source can be used as the diazonium salt in this case.

For example, when the exposure is performed by light of 436 nm, a 2-(N,N-dimethylamino)-5-methylthiobenzenediazonium salt, a 2,4',5-triethoxy-4-biphenyldiazonium salt, a 2,5-diethoxy-4-(p-tolylthio)benzenediazonium salt, a 4-dimethylaminonaphthalenediazonium salt,

an N,N-bis(4-diazophenyl)amine salt, a 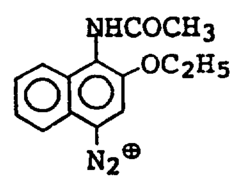 salt,

a 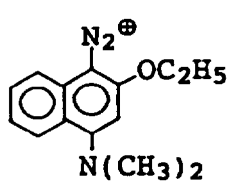 salt, a 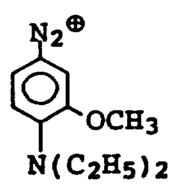 salt, a 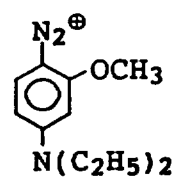 salt,

etc. can be used as the diazonium salt; and when the exposure is performed by light of 365 nm,

a 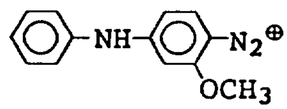

salt, a 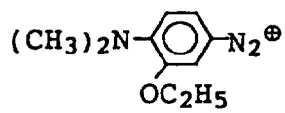 salt, a 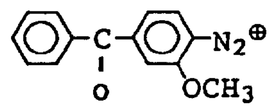 salt, a 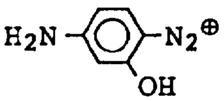 salt, a 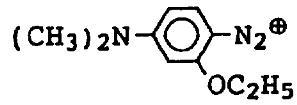 salt, a 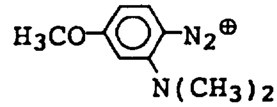 salt, a 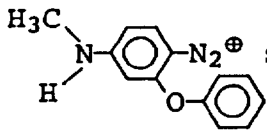 salt, a 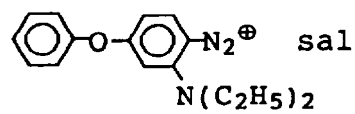 salt, a 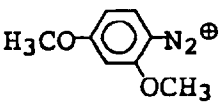 salt, a 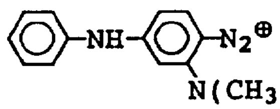 salt, etc. can be used as the diazonium salt.

After spin-coating the photosensitive resin, the assembly is exposed by a light sensitive to both the upper layer and the lower layer and then developed with a developer of the resist, just then, dissolving off the photosensitive resin layer at the same time, to thereby produce fine patterns of the resist on the wafer.

The present invention is explained with reference to the following examples, but it is not to be construed that the invention is limited thereto.

PREPARATION EXAMPLE I

After 2 equivalents of 1,5-naphthalenedisulfonic acid had been added to an aqueous 4-α-naphthylaminobenzenediazonium chloride solution synthesized by the conventional method, a diazonium salt was allowed to deposit by salting out from the resulting solution and dried in vacuo to give a powdery diazonium salt.

EXAMPLE I

To 7.2 g of the diazonium salt obtained in Preparation Example 1 were added 10 g of sodium polystyrenesulfonate (PS-5, manufactured by Toyo Soda Manufacturing Co., Ltd., molecular weight: 50,000) and 90 g of water to prepare a photosensitive resin solution.

The photosensitive resin solution was spin-coated on a quartz substrate to form a uniform thin film having a thickness of 0.25 μm. The A value at 436 nm obtained by measuring the transmittance of the film before and after the exposure was 6.9. Then, the photosensitive resin solution was left to stand for 25 days at 35°C in a thermostat and, thereafter, the A value was again measured and found to be 6.5. It is obvious that the storage stability was good without showing any change in the thickness of the coated film.

COMPARATIVE EXAMPLE I

An aqueous photosensitive resin solution was prepared by mixing 3 g of a 4-α-naphthylaminobenzenediazonium l/2 $ZnCl_2$ salt as the diazonium salt, l0 g of polyvinylpyrrolidone (manufactured by Nakarai Kagaku Yakuhin K.K., molecular weight: 24,500), and 90 g of water. The A value obtained by the same evaluation method as in Example I was 4.6. In addition, when the resin solution contained the diazonium salt in an amount larger than the above, no uniform film could be formed owing to the deposition of crystals in the coated film. Further, the A value examined after storage for 20 days at 35°C as in Example 1 was found to be 1.6 which showed unsuitability of the photosensitive resin for practical use.

EXAMPLE 2

A positive photoresist, OFPR-800 (manufactured by Tokyo Ohka Kogyo Co., Ltd.) was spin-coated on a silicon wafer at a thickness of 0.9 μm and, thereafter, the coated layer was prebaked for 10 minutes at 80°C. Then, the photosensitive resin solution prepared in Example 1 was spin-coated thereon at a thickness of 0.25 μm.

Next, exposure was made by a g-line (436 nm) 5/1-reduction projection exposure apparatus (stepper) equipped with a numerical aperture of 0.42, and development was performed by the use of a developer, NMD-3 (manufactured by Tokyo Ohka Kogyo Co., Ltd.). The cross-sectional shape of the resist pattern thus obtained was observed by a scanning electron microsope, and it was found that there was obtained a 0.60 μm line/space pattern having rectangular steep edges.

COMPARATIVE EXAMPLE 2

A resist pattern was obtained in the same manner as in Example 2 except that the spin-coating of the photosensitive resin was omitted. In this case, however, the exposure dose required for the pattern transfer was about 1/2 of that in Example 1. A 0.6 μm pattern could not be resolved, observing by a scanning electron microscope.

COMPARATIVE EXAMPLE 3

A pattern transfer was performed in the same manner as in Example 2 except that the photosensitive resin solution obtained in Comparative Example 1 was used in place of the photosensitive resin solution obtained in Example 1. A 0.6 μm pattern could be resolved, but the shape of the resist pattern was too poor to be used in practice.

PREPARATION EXAMPLE 2

Using p-chloronitrobenzene and p nitroaniline as the starting materials, the following compound was synthesized by the conventional method.

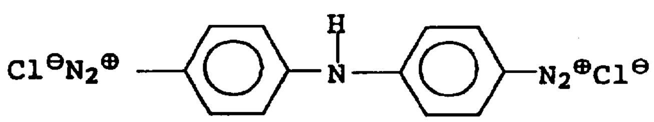

(Compound I)

Then, after addition of 4 equivalents of 1,5-naphthalenedisulfonic acid, a diazonium salt was allowed to deposit by salting out and dried in vacuo.
To 9.5 g of this powder of the diazonium salt of Compound I were added 10 g of ammonium polystyrenesulfonate (the sodium in PS-5 was replaced by ammonium by the use of an ion exchange resin and dehydrated to dryness) and 90 g of water to prepare a photosensitive resin solution.

EXAMPLE 3

The photosensitive resin solution obtained in Preparation Example 2 was spin-coated on a quartz substrate to form a uniform thin film having a thickness of 0.29 μm. The A value at 436 nm was found to be 9.8. Then, after the photosensitive resin solution had been left to stand for 20 days at 35°C in a thermostat, the A value was again measured and found to be 9.3, so that there was no degradation in coating properties and the storage stability was good.

COMPARATIVE EXAMPLE 4

A photosensitive resin solution was prepared by mixing 1.8 g of a diazonium salt (a compound described below), 10 g of polyvinylpyrrolidone (manufactured by Nakarai Kagaku Yakuhin K.K., molecular weight: 24,500), and 90 g of water, and the A value was measured to be 4.8.

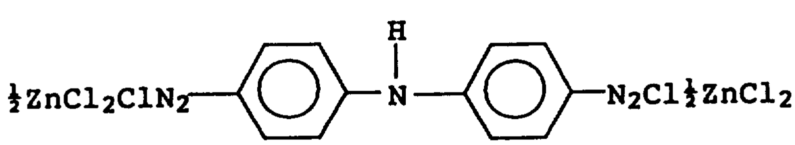

In addition, when the diazonium salt was dissolved in this photosensitive resin solution, crystals deposited in the coated film, so that no uniform film could be formed.

For the storage stability test, the photosensitive resin solution was left to stand for 20 days at 35°C in a thermostat and, then, the A value was again measured. As it was l.2, the photosensitive resin solution could not be used in practice.

EXAMPLE 4

A positive photoresist, OFPR-800 was spin-coated on a silicon wafer at a thickness of 0.9 μm and, thereafter, the coated layer was prebaked for 10 minutes at 80°C. Then, the photosensitive solution prepared in Preparation Example 2 was spin coated thereon at a thickness of 0.22 μm.

Next, exposure was performed by a g-line (436 nm) 5/l stepper equipped with a numerical aperture of 0.35, and development was performed by the use of a developer, NMD-3. The cross-sectional shape of the resist pattern thus obtained was observed by a scanning electron microscope, whereby it was found that there was obtained a rectangular and sharp 0.75 μm line/space pattern.

COMPARATIVE EXAMPLE 5

An experiment was carried out in the same manner as in Example 4 except that the photosensitive resin solution prepared in Comparative Example 4 was used in place of the photosensitive resin solution prepared in Preparation Example 2. In this case, however, the exposure amount was sufficient when it was less by 30% than that in Example 4.

The observation by a scanning electron microscope showed that the resolution was 1.15 μm.

PREPARATION EXAMPLE 3

After 2 equivalents of 1,5-naphthalenedisulfonic acid had been added to an aqueous solution of

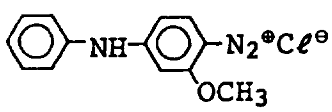

synthesized by the conventional method, a diazonium salt was allowed to deposit by salting out from the resulting solution and dried in vacuo to give a powdery diazonium salt.

EXAMPLE 5

To 8.0 g of the diazonium salt obtained in Preparation Example 3 were added 10 g of PS-5 and 90 g of water to prepare a photosensitive resin solution.

The photosensitive resin solution was spin-coated on a quartz substrate to form a uniform thin film having a thickness of 0.25 μm. The A value at 365 nm obtained by measuring the transmittance of the film before and after the exposure was 11.5. Then, the photosensitive resin solution was left to stand for 25 days at 35°C in a thermostat and, thereafter, the A value was again measured and found to be 11.4. It is obvious that the storage stability was good without showing any change in the thickness of the coated film.

COMPARATIVE EXAMPLE 6

An aqueous photosensitive resin solution was prepared by mixing 3 g of

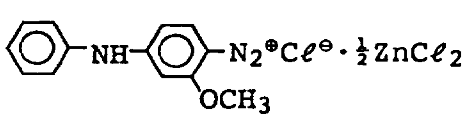

as the diazonium salt, 10 g of polyvinylpyrrolidone (manufactured by Nakarai Kagaku Yakuhin K.K., molecular weight: 24,500), and 90 g of water. The A value obtained by the same evaluation method as in Example 5 was 7.3. In addition, when the resin solution contained the diazonium salt in an amount larger than the above, no uniform film could be formed owing to the deposition of crystals in the coated film. Further, the A value examined after storage for 20 days at 35°C as in Example 1 was found to be 2.0 which showed unsuitability of the photosensitive resin for practical use.

EXAMPLE 6

A positive photoresist, OFPR-800 was spin-coated on a silicon wafer at a thickness of 0.9 μm and, thereafter, the coated layer was prebaked for 10 minutes at 80°C. Then, the photosensitive resin solution prepared in Example 5 was spin-coated thereon at a thickness of 0.25 μm.

Next, exposure was made by an i-line (365 nm) 10/1-reduction projection exposure apparatus (stepper) equipped

with a numerical aperture of 0.42, and development was performed by the use of a developer, NMD-3. The cross sectional shape of the resist pattern thus obtained was observed by a scanning electron microsope, and it was found that there was obtained a 0.60 µm line/space pattern having rectangular steep edges.

COMPARATIVE EXAMPLE 7

A resist pattern was obtained in the same manner as in Example 6 except that the spin-coating of the photosensitive resin was omitted. In this case, however, the exposure dose required for the pattern transfer was about 1/2 of that in Example 1. A 0.6 µm pattern could not be resolved, observing by a scanning electron microscope.

COMPARATIVE EXAMPLE 8

A pattern transfer was performed in the same manner as in Example 6 except that the photosensitive resin solution obtained in Comparative Example 6 was used in place of the photosensitive resin solution obtained in Example 5. A 0.6 µm pattern could be resolved, but the shape of the resist pattern was too poor to be used in practice.

PREPARATION EXAMPLE 4

The following compound was synthesized by the conventional method.

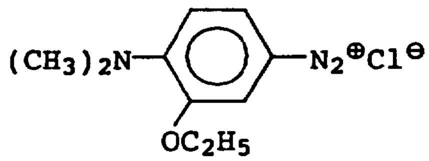

(Compound II)

Then, after addition of 2 equivalents of 1,5-naphthalenedisulfonic acid, a diazonium salt was allowed to deposit by salting out and dried in vacuo. To 9.8 g of this powder of the diazonium salt of
Compound II were added 10 g of ammonium polystyrenesulfonate (the sodium in PS-5 was replaced by ammonium by the use of an ion exchange resin and dehydrated to dryness) and 90 g of water to prepare a photosensitive resin solution.

EXAMPLE 7

The photosensitive resin solution obtained in Preparation Example 4 was spin coated on a quartz substrate to form a uniform thin film having a thickness of 0.30 µm. The A value at 365 nm was found to be l2.0. Then, after the photosensitive resin solution had been left to stand for 20 days at 35°C in a thermostat, the A value was again measured and found to be 11.8, so that there was no degradation in coating properties and the storage stability was good.

COMPARATIVE EXAMPLE 9

A photosensitive resin solution was prepared by mixing 2.2 g of a diazonium salt (a compound described below), 10 g of polyvinylpyrrolidone (manufactured by Nakarai Kagaku Yakuhin K.K., molecular weight: 24,500), and 90 g of water, and the A value was measured to be 5.1.

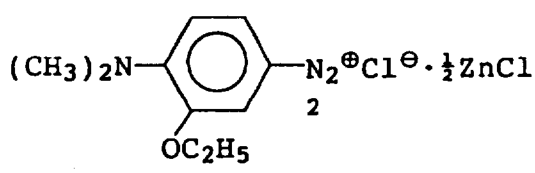

In addition, when the diazonium salt was dissolved in this photosensitive resin solution, crystals deposited in the coated film, so that no uniform film could be formed.

For the storage stability test, the photosensitive resin solution was left to stand for 20 days at 35°C in a thermostat and, then, the A value was again measured. As it was 1.0, the photosensitive resin solution could not be used in practice.

EXAMPLE 8

A positive photoresist, OFPR-800 was spin coated on a silicon wafer at a thickness of 0.9 µm and, thereafter, the coated layer was prebaked for 10 minutes at 80°C. Then, the photosensitive solution prepared in Preparation Example

4 was spin-coated thereon at a thickness of 0.22 µm.

Next, exposure was performed by an i-line (365 nm) 10/1 stepper equipped with a numerical aperture of 0.35, and development was performed by the use of a developer, NMD-3. The cross-sectional shape of the resist pattern thus obtained was observed by a scanning electron microscope, whereby it was found that there was obtained a rectangular and sharp 0.7 µm line/space pattern.

COMPARATIVE EXAMPLE 10

An experiment was carried out in the same manner as in Example 8 except that the photosensitive resin solution prepared in Comparative Example 9 was used in place of the photosensitive resin solution prepared in Preparation Example 4. In this case, however, the exposure amount was sufficient when it was less by 30% than that in Example 8.

The observation by a scanning electron microscope showed that the resolution was 1.10 µm.

In accordance with this invention, on account of the fact that a large amount of a diazonium salt can be dissolved in a photosensitive resin composition, not only the resolution but also the stability of the diazonium salt can be improved and, therefore, resist patterns of 1 µm or less can be produced with good resolution as well as good reproducibility. These effects of this invention may be of industrially great value from the viewpoint that it can contribute to the lithography for recently producing finer circuit pattern width in the manufacture of semiconductor.

## Claims

1. A photosensitive resin composition comprising, (a) water, (b) a polymer containing an organic acid group whose pKa value is not more than 2 and (c) a diazonium salt whose counter anion is a sulfonic group-containing compound represented by formulae (I) and/or (II):

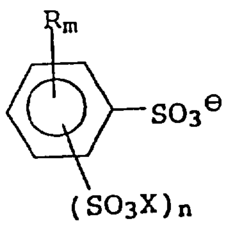

(I)

wherein R is a hydrogen atom, an alkyl group, an aryl group, an aralkyl group, an alkoxy group, a phenyl group, a halogen atom, a hydroxyl group, or a carboxyl group; X is a hydrogen atom, a lithium atom, a sodium atom, a potassium atom, or an ammonium group; and m and n are each an integer of from 1 to 5, provided that the sum of m and n is not higher than 5,

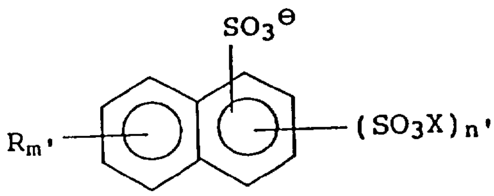

(II)

wherein R and X are the same as defined above; and m' and n' are each an integer of from 1 to 7, provided that the sum of m' and n' is not higher than 7.

2. A photosensitive resin composition as in claim 1, wherein the polymer containing an organic acid group whose pKa value is not more than 2 is of the structure containing a sulfonic group.

3. A photosensitive resin composition as in claim 1 or 2, wherein the polymer in said photosensitive resin has a structural unit shown by formula (III):

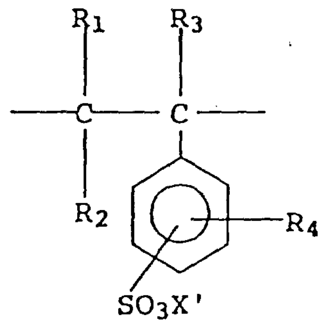

(III)

wherein $R_1$, $R_2$ and $R_3$ each represents a hydrogen atom, an alkyl group having from 1 to 4 carbon atoms, a halogen atom, or a nitrile group; $R_4$ represents a hydrogen atom, an alkyl group having from 1 to 4 carbon atoms, a halogen atom, a hydroxyl group, or a carboxyl group; and X' represents a hydrogen atom, an alkali metal, an alkaline earth metal, or an ammonium group.

**4.** A method for producing fine patterns comprising spin-coating a resist layer as a lower layer on a substrate ; further spin-coating a solution of a photo-sensitive resin composition as an upper layer on said lower layer; and then light-exposing both said upper layer and said lower layer, wherein said photosensitive resin composition comprises water, a polymer containing an organic acid group whose pKa value is not more than 2, and a diazonium salt whose counter anion is a sulfonic group-containing compound represented by formulae (I) and/or (II):

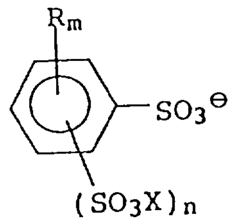

(I)

wherein R is a hydrogen atom, an alkyl group, an aryl group, an aralkyl group, an alkoxy group, a phenyl group, a halogen atom, a hydroxyl group, or a carboxyl group; X is a hydrogen atom, a lithium atom, a sodium atom, a potassium atom, or an ammonium group; and m and n are each an integer of from 1 to 5, provided that the sum of m and n is not higher than 5,

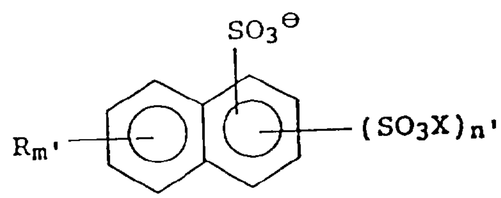

(II)

wherein R and X are the same as defined above, and m' and n' are each an integer of from 1 to 7, provided that the sum of m' and n' is not higher than 7.

**5.** A method as in claim 4, wherein the polymer containing an organic acid group whose pKa value is not more than 2 is of the structure containing a sulfonic group.

**6.** A method as in claim 4 or 5, wherein the polymer in said photosensitive resin has a structural unit shown by formula (III):

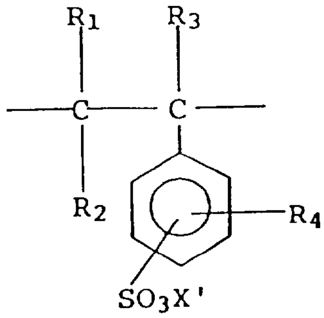

(III)

wherein $R_1$, $R_2$ and $R_3$ each represents a hydrogen atom, an alkyl group having from 1 to 4 carbon atoms, a halogen atom, or a nitrile group; $R_4$ represents a hydrogen atom, an alkyl group having from 1 to 4 carbon atoms, a halogen atom, a hydroxyl group, or a carboxyl group; and X' represents a hydrogen atom, an alkali metal, an alkaline earth metal, or an ammonium group.

**Patentansprüche**

1. Lichtempfindliche Harzzusammensetzung umfassend (a) Wasser, (b) ein Polymer, enthaltend eine organische Säuregruppe, deren pKa-Wert nicht größer als 2 ist und (c) ein Diazoniumsalz dessen Gegenanion eine sulfonsäurehaltige Verbindung der Formeln (I) und/oder (II) ist

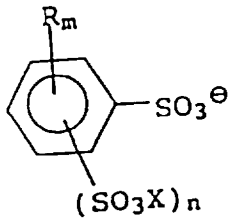

(I)

wobei R ein Wasserstoffatom, ein Alkylrest, ein Arylrest, ein Aralkylrest, ein Alkoxyrest, eine Phenylgruppe, ein Halogenatom, eine Hydroxylgruppe oder eine Carbonsäuregruppe ist; X ein Wasserstoffatom, ein Lithiumatom, ein Natriumatom, ein Kaliumatom oder eine Ammoniumgruppe ist; und m und n jeweils eine ganze Zahl von 1 bis 5 bedeuten, mit der Maßgabe, daß die Summe von m und n nicht größer als 5 ist;

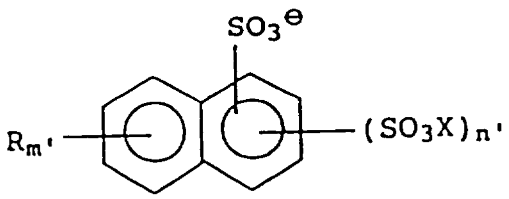

(II)

wobei R und X wie vorstehend definiert sind, und m' und n' jeweils eine ganze Zahl von 1 bis 7 bedeuten, mit der Maßgabe, daß die Summe von m' und n' nicht größer als 7 ist.

2. Lichtempfindliche Harzzusammensetzung nach Anspruch 1, wobei das Polymer, enthaltend eine organische Säuregruppe, deren pKa-Wert nicht höher als 2 ist, eine eine Sulfonsäuregruppe enthaltende Struktur aufweist.

3. Lichtempfindliche Harzzusammensetzung nach Anspruch 1 oder 2, wobei das Polymer in dem lichtempfindlichen Harz eine Struktureinheit der Formel (III) aufweist:

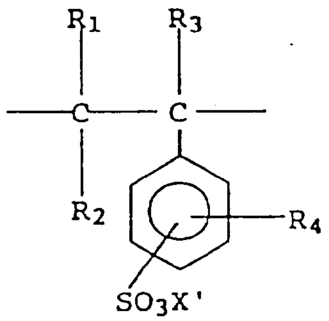

(III)

wobei $R_1$, $R_2$ und $R_3$ jeweils ein Wasserstoffatom, ein Alkylrest mit 1 bis 4 Kohlenstoffatomen, ein Halogenatom oder eine Nitrilgruppe bedeuten; $R_4$ ein Wasserstoffatom, ein Alkylrest mit 1 bis 4 Kohlenstoffatomen, ein Halogenatom, eine Hydroxylgruppe oder eine Carbonsäuregruppe bedeutet und X' ein Wasserstoffatom, ein Alkalimetall, ein Erdalkalimetall oder eine Ammoniumgruppe darstellt.

**4.** Verfahren zur Herstellung von feinen Mustern, umfassend Rotationsbeschichten (spin-coating) einer Resist-Schicht als untere Schicht auf einem Substrat; ferner Rotationsbeschichten einer Lösung einer lichtempfindlichen Harzzusammensetzung als obere Schicht auf der unteren Schicht und nachfolgendes Belichten sowohl der oberen als auch der unteren Schicht, wobei die lichtempfindliche Harzzusammensetzung Wasser, ein Polymer, enthaltend eine organische Säuregruppe, deren pKa-Wert nicht größer als 2 ist, und ein Diazoniumsalz dessen Gegenanion eine sulfonsäurehaltige Verbindung der Formeln (I) und/oder (II) ist

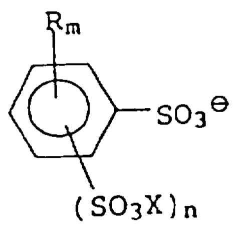

(I)

wobei R ein Wasserstoffatom, ein Alkylrest, ein Arylrest, ein Aralkylrest, ein Alkoxyrest, eine Phenylgruppe, ein Halogenatom, eine Hydroxylgruppe oder eine Carbonsäuregruppe ist; X ein Wasserstoffatom, ein Lithiumatom, ein Natriumatom, ein Kaliumatom oder eine Ammoniumgruppe ist; und m und n jeweils eine ganze Zahl von 1 bis 5 bedeuten, mit der Maßgabe, daß die Summe von m und n nicht größer als 5 ist;

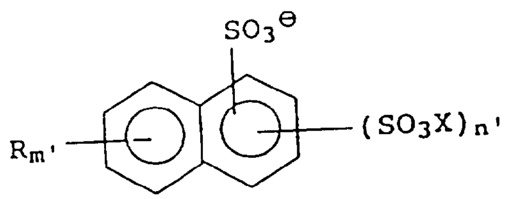

(II)

wobei R und X wie vorstehend definiert sind, und m' und n' jeweils eine ganze Zahl von 1 bis 7 bedeuten, mit der Maßgabe, daß die Summe von m' und n' nicht größer als 7 ist.

**5.** Verfahren nach Anspruch 4, wobei das Polymer enthaltend eine organische Säuregruppe, deren pKa-Wert nicht höher als 2 ist, eine eine Sulfonsäuregruppe enthaltende Struktur aufweist.

**6.** Verfahren nach Anspruch 4 oder 5, wobei das Polymer in dem lichtempfindlichen Harz eine Struktureinheit der Formel (III) aufweist:

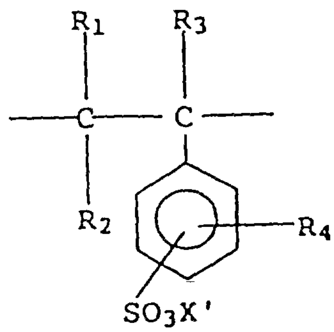

(III)

wobei $R_1$, $R_2$ und $R_3$ jeweils ein Wasserstoffatom, ein Alkylrest mit 1 bis 4 Kohlenstoffatomen, ein Halogenatom oder eine Nitrilgruppe bedeuten; $R_4$ ein Wasserstoffatom, ein Alkylrest mit 1 bis 4 Kohlenstoffatomen, ein Halogenatom, eine Hydroxylgruppe oder eine Carbonsäuregruppe bedeutet und X' ein Wasserstoffatom, ein Alkalimetall, ein Erdalkalimetall oder eine Ammoniumgruppe darstellt.

**Revendications**

**1.** Composition de résine photosensible comprenant (a) de l'eau; (b) un polymère contenant un groupe acide organique dont la valeur du pKa n'est pas supérieure à 2 et (c) un sel de diazonium dont le contre-anion est un composé contenant des groupes sulfoniques représenté par les formules (I) et/ou (II):

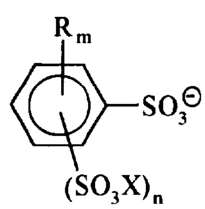

(I)

où R est un atome d'hydrogène, un groupe alkyle, un groupe aryle, un groupe aralkyle, un groupe alcoxy, un groupe phényle, un atome d'halogène, un groupe hydroxyle ou un groupe carboxyle; X est un atome d'hydrogène, un atome de lithium, un atome de sodium, un atome de potassium ou un groupe ammonium; et m et n sont chacun un entier de 1 à 5, à condition que la somme de m et n ne soit pas supérieure à 5,

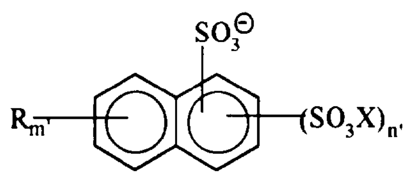

(II)

où R et X ont les définitions données ci-dessus; et m' et n' sont chacun un entier de 1 à 7, à condition que la somme de m' et n' ne soit pas supérieure à 7.

**2.** Composition de résine photosensible selon la revendication 1, dans laquelle le polymère contenant un groupe acide organique dont la valeur de pKa n'est pas supérieure à 2 a une structure contenant un groupe sulfonique.

**3.** Composition de résine photosensible selon la revendication 1 ou 2, dans laquelle le polymère dans ladite résine photosensible a une unité constitutive représentée par la formule (III)

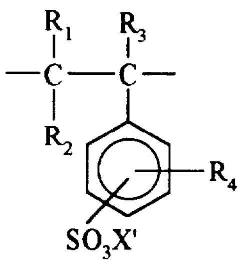

(III)

dans laquelle $R_1$, $R_2$ et $R_3$ représentent chacun un atome d'hydrogène, un groupe alkyle de 1 à 4 atomes de carbone, un atome d'halogène ou un groupe nitrile; $R_4$ représente un atome d'hydrogène, un groupe alkyle de 1 à 4 atomes de carbone, un atome d'halogène, un groupe hydroxyle ou un groupe carboxyle; et X' représente un atome d'hydrogène, un métal alcalin, un métal alcalino-terreux ou un groupe ammonium.

4. Procédé de production de configurations fines comprenant l'application par rotation d'une couche de résist en tant que couche inférieure sur un substrat; puis l'application par rotation sur ladite couche inférieure d'une couche d'une solution d'une composition de résine photosensible en tant que couche supérieure; et ensuite l'exposition à la lumière à la fois de ladite couche inférieure et de ladite couche supérieure, ladite composition de résine photosensible comprenant de l'eau, un polymère contenant un groupe acide organique dont la valeur du pKa n'est pas supérieure à 2 et un sel de diazonium dont le contre-anion est un composé contenant des groupes sulfoniques représenté par les formules (I) et/ou (II):

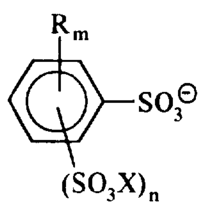

(I)

où R est un atome d'hydrogène, un groupe alkyle, un groupe aryle, un groupe aralkyle, un groupe alcoxy, un groupe phényle, un atome d'halogène, un groupe hydroxyle ou un groupe carboxyle; X est un atome d'hydrogène, un atome de lithium, un atome de sodium, un atome de potassium ou un groupe ammonium; et m et n sont chacun un entier de 1 à 5, à condition que la somme de m et n ne soit pas supérieure à 5,

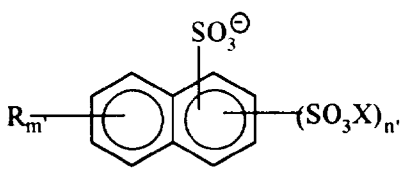

(II)

où R et X ont les définitions données ci-dessus; et m' et n' sont chacun un entier de 1 à 7, à condition que la somme de m' et n' ne soit pas supérieure à 7.

5. Procédé selon la revendication 4, dans lequel le polymère contenant un groupe acide organique dont la valeur de pKa n'est pas supérieure à 2 a une structure contenant un groupe sulfonique.

6. Procédé selon la revendication 4 ou 5, dans lequel le polymère dans ladite résine photosensible a une unité constitutive représentée par la formule (III)

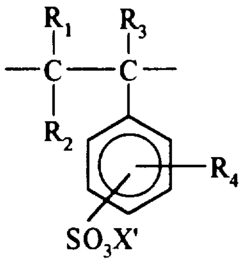

(III)

dans laquelle $R_1$, $R_2$ et $R_3$ représentent chacun un atome d'hydrogène, un groupe alkyle de 1 à 4 atomes de carbone, un atome d'halogène ou un groupe nitrile; $R_4$ représente un atome d'hydrogène, un groupe alkyle de 1 à 4 atomes de carbone, un atome d'halogène, un groupe hydroxyle ou un groupe carboxyle; et X' représente un atome d'hydrogène, un métal alcalin, un métal alcalino-terreux ou un groupe ammonium.